**Europäisches Patentamt**

**European Patent Office**

**Office européen des brevets**

(19)

(11) Publication number : **0 469 926 A1**

## (12) EUROPEAN PATENT APPLICATION

(21) Application number : **91307124.7**

(22) Date of filing : **02.08.91**

(51) Int. Cl.$^5$ : **C08J 7/06, B65D 65/40, C23C 16/40**

(30) Priority : **03.08.90 US 562119**

(43) Date of publication of application :
**05.02.92 Bulletin 92/06**

(84) Designated Contracting States :
**AT BE CH DE DK ES FR GB GR IT LI LU NL SE**

(71) Applicant : **THE BOC GROUP, INC.**
**575 Mountain Avenue**
**Murray Hill New Jersey 07974 (US)**

(72) Inventor : **Felts, John T.**
**2624 Calhoun Street**
**Alameda, California 94501 (US)**

(74) Representative : **Bousfield, Roger James et al**
**The BOC Group plc Chertsey Road**
**Windlesham Surrey GU20 6HJ (GB)**

(54) **Silicon oxide based thin film vapour barriers.**

(57) A flexible polymer substrate, particularly useful for medical or food packaging applications, defines a surface that carries a thin film. The thin film has a thickness less than about 1000 Å and preferably the surface and thin film together have a permeability to oxygen gas that is less than about 0.1 cc/100in$^2$/day. The thin film includes a substantially inorganic silicon oxide. The film is deposited in a previously evacuated chamber by glow discharge from a gas stream that includes a volatilized organosilicon component, an oxygen component, and an inert gas component.

FIG._1.

EP 0 469 926 A1

The present invention relates to the deposition of silicon oxide based films, and more particularly to the plasma enhanced deposition of silicon oxide based thin films on substrates providing gas transmission barriers and useful for packaging applications.

This application is a continuation-in-part of pending serial number 07/426,514, filed October 24, 1989, that is a continuation of 07/073,792, filed July 15, 1987, now abandoned, of common assignment herewith.

Plasma polymerization has been a known technique to form films on various substrates. For example, mixtures of silane with or without oxygen, nitrous oxide or ammonia have been plasma polymerized to form silicon oxide films. However, silane has a repulsive odor, can be irritating to the respiratory tract and is pyrophoric and corrosive.

Some attention turned from silane to the deposition of organosilicon films from plasmas. Sharma and Yasuda, Thin Solid Films, 110, pages 171-184 (1983) reviewed the preparation of films from several organosilicon compounds in which silicon based polymers were deposited and described the plasma polymerization of tetramethyldisiloxane by a magnetron glow discharge with the addition of oxygen gas. The films so formed were reduced in carbon to silicon ratio with respect to the organosilicon starting material, but still retained a significant amount of carbon. However, the incorporation of oxygen in the feed mixture, despite silicon enrichment of the film, resulted in poor polymer adhesion.

Sacher et al., U.S. Patent No. 4,557,946, issued December 10, 1985 describes use of plasma polymerized coatings from organosilicon compounds to form a moisture barrier on the substrate by heating the substrate and controlling the plasma power level. Wertheimer et al., U.S. Patent No. 4,599,678, issued July 8, 1986, discloses use of an organosilicon in a glow discharge to coat thin film capacitors when these substrates are heated to a temperature in excess of 50° C.

In general, the films formed from organosilicons have typically been formed at a relatively low deposition rate (as compared with, for example, sputtering), have tended to be soft, and often have been hazy. The requirement that the substrate be heated, as in Sacher et al. and Wertheimer et al., is also disadvantageous for some substrates.

A further problem with use of organosilicon compounds in plasma enhanced deposition has been the variation in polymerization conditions and lack of control during the deposition. The traditional method used to control plasma processes has been the use of power, pressure and flow to monitor and attempt to control the process. However, these three variables represent inputs and do not accordingly control the thin films being produced. As a consequence, the scale-up of such a process is extremely complex.

Films with reduced permeability to vapors such as water, oxygen, and carbon dioxide are useful for a variety of applications, one of which is to package foods. Such films are typically composites of materials. For example, one layer is often a flexible polymer, such as a polyethylene or polypropylene, while another layer is coated on or coextruded with the one layer and serves as a barrier layer. Barrier layers can generally be viewed as substantially organic based or substantially inorganic based.

Inorganic barrier coatings typically are advantageously inert. These inorganic coatings can be produced as thin layers in vacuum deposition chambers. For example, U.S. Patent 3,442,686, issued May 6, 1969, inventor Jones, describes a packaging film composite in which silicon oxide coatings in the range of 0.2 to 2 microns are produced by electron beam evaporation of silicon monoxide in a vacuum chamber. The patentee describes these inorganic coatings as substantially continuous. More recently, U.S. Patent 4,702,963, issued October 27, 1987, inventors Phillips et al., describes flexible polymer packaging films having thin films of inorganic coatings. The inorganic coatings are silicon dioxide or monoxide in which at least chromium, tantalum, nickel, molybdenum, or oxides of these materials are co-deposited and are said to serve as an adhesion layer and assist in lower gas and vapor permeability. Layer thickness of 1000 Å and 2500 Å are exemplified and produced in a roll coating machine with vacuum deposition chambers.

However, the barrier coatings described by U.S. Patent 3,442,686 have oxygen transmission rate properties on the order of about 0.2 cc/100in²/day and water vapor transmission rate properties on the order of about 0.2 g/100in²/day. The packaging films exemplified by U.S. Patent 4,702,963 have somewhat better barrier properties, but are on the order of having oxygen transmission rate properties of about 0.17 cc/100in²/day and water vapor transmission rates of about 0.07 g/100in²/day. These values are still higher than could be desired since there are many applications in the food, beverage, and medical fields where the material being packaged is quite sensitive to oxygen degradation. Of course, barrier properties can be further improved by additional layers of different materials and/or by aluminizing, but this leads to difficulties in an ability to recycle, with toxicity, and with costs.

Figure 1 is a general schematic diagram illustrating a plasma system useful in practicing the present invention;

Figure 2 schematically illustrates a side sectional view of the plasma deposition chamber and its associated equipment;

Figure 3 is an example spectrum of the emission of plasma;

Figures 4A, 4B and 4C illustrate the bonding of components of a molecule of a gas used in an example plasma enhanced chemical vapor deposition process;

Figure 5 includes a series of curves that illustrate the electron energy distribution in an example plasma;

Figure 6 is an example energy level diagram for a single species in a plasma;

Figure 7 is a flow diagram for a computer program that controls plasma process input variables in response to the measured plasma spectra;

Figures 8A and 8B illustrate the use of a balanced magnetron in the system of Figure 2;

Figures 9A and 9B illustrate the use of an unbalanced magnetron in the system of Figure 2; and,

Figure 10 illustrates an alternative connection to a magnetron in the system of Figure 2 wherein the electric field is produced by a radio frequency generator.

It is an object of the invention to reproducibly deposit adherent, hard silicon oxide based thin films at commercially feasible deposition rates on small or large substrates, preferably with preselected gas barrier properties.

In one aspect of the invention, a method of depositing an adherent, silicon oxide based thin film comprises providing a gas stream with at least three components, establishing a glow discharge plasma derived from the gas stream, or one of its components, in a previously evacuated chamber with a flexible substrate removably positioned in the plasma, and controllably flowing the gas stream into the plasma to deposit a silicon oxide film having a predetermined thickness, preferably less than about 1000 Å for thin, flexible substrates, onto the substrate when positioned in the plasma. A pressure less than about 0.1 Torr is maintained during the depositing. The gas stream includes a volatilized organosilicon compound, oxygen, and an inert gas such as helium or argon.

The gas stream is controllably flowed into the plasma by volatilizing the organosilicon exterior to the chamber and admixing metered amounts with oxygen and the inert gas. The control of flowing gas stream into the plasma preferably includes adjusting the amounts of components in the gas stream during the deposition in response to monitored values of hydrogen (alpha) to inert gas emission lines and electron temperature in the plasma. The flowing control also includes depositing the silicon oxide layer having a predetermined thickness.

Films of the invention can be controllably deposited on a variety of large or small substrates for applications in which a substantially inert film providing good gas transmission barrier properties is desired. It has been discovered that gas transmission properties are a function of film thickness and surprisingly have an optimal range of thickness to provide the maximal barrier properties, with both thicker and thinner films outside the optimal range having less desirable barrier properties.

In another aspect of the present invention, an article of the invention comprises a flexible polymer substrate defining a surface and a thin film carried by the surface. The polymer surface and a thin film together have a permeability to oxygen gas that is less than about 0.1 cc/100in²/day and the thin film has a thickness less than about 1000 Å, more preferably less than about 600 Å, most preferably the thin film has a thickness between about 100 Å to about 400 Å and the coated surface has an oxygen permeability of less than about 0.04 cc/100in²/day. Such articles are useful where inert, flexible packagings with excellent vapor and gas barrier properties are required, such as for serum and blood bags in medical applications and for food packaging of very oxygen-sensitive foods.

The present invention provides a method of depositing silicon oxide based films that are hard, adherent, substantially inorganic and have excellent gas barrier properties. Such films have been deposited in accordance with the invention on a variety of substrates (flexible and rigid) and preferably have film thicknesses less than about 1000 Å for flexible substrates. By "flexible substrates" is generally meant those less than about 10 mils thick. The very thin films provide good vapor barrier properties and although thicker films can be obtained, such are not normally desired for vapor barrier applications on flexible substrates.

Choice of the flexible substrate to be coated by the invention will vary according to the desired application. For example, various flexible plastics such as polyethyleneterephthalate (PET) or polycarbonate (PC) resins, useful for packaging foods, may be coated in accordance with the invention to retard oxygen, carbon dioxide or moisture permeation. Although thicknesses of flexible substrates will be up to about 10 mils, the thicknesses are usually about 0.5 - 1 mil for food packaging applications.

Although the process has an organosilicon compound as a starting material, the preferred films are substantially inorganic as evidenced by bonding analysis. However, films that are silicone in nature may be prepared if desired, as further described hereinafter. The typical, substantially inorganic silicon oxide based films deposited in accordance with the invention are characterized by a high degree of crosslinking (determined by Fourier transform infrared spectroscopy, or FTIR).

The inventive method is conducted in a previously evacuated chamber by glow discharge from a gas stream including at least three components: a volatilized organosilicon component, an oxygen component and an inert

EP 0 469 926 A1

gas component. The combination of oxygen component and inert gas component with the volatilized organosilicon component has been found to greatly increase the hardness property of thin films.

Films prepared either with the organosilicon combined only with oxygen or the organosilicon combined only with an inert gas such as helium or argon had a hardness measured by the ASTM D3363-74 (standard test method for film hardness) pencil test of only 2 or 3. By contrast, films made in accordance with the invention have hardnesses by this test of about 7 to about 9+. The numbers reported are based on a scale of 0 to 10 where 0 means the least scratch resistance, while 10 means there was no damage to the coating when abraded in accordance with ASTM D3363-74. Accordingly, thin films prepared in accordance with the invention are typically harder by a factor of 2 or 3 with respect to films deposited with the volatilized organosilicon component in combination with either oxygen or inert gas.

Suitable organosilicon compounds for the gas stream are liquid at about ambient temperature and when volatilized have a boiling point above about ambient temperature and include methylsilane, dimethylsilane, trimethylsilane, diethylsilane, propylsilane, phenylsilane, hexamethyldisilane, 1,1,2,2-tetramethyl disilane, bis(trimethylsilyl) methane, bis(dimethylsilyl) methane, hexamethyldisiloxane, vinyl trimethoxy silane, vinyl triethoxy silane, ethylmethoxy silane, ethyltrimethoxy silane, divinyltetramethyldisiloxane, divinylhexamethyltrisiloxane, and trivinylpentamethyl-trisiloxane.

Among the preferred organosilicons are 1,1,3,3-tetramethyldisiloxane, hexamethyldisiloxane, vinyltrimethylsilane, methyltrimethoxysilane, vinyltrimethoxysilane and hexamethyldisilazane. These preferred organosilicon compounds have boiling points of 71° C, 101° C, 55.5° C, 102° C, 123° C, and 127° C, respectively.

The volatilized organosilicon component is preferably admixed with the oxygen component and the inert gas component before being flowed into the chamber. The quantities of these gases being so admixed are controlled by flow controllers so as to adjustably control the flow rate ratio of the gas stream components.

The organosilicon compound and oxygen of the gas stream during the depositing may be, for example, in a flow rate ratio of about 1.7:1 and the inert gas of the gas stream preferably is helium or argon, more preferably is helium. When the inert gas is helium or argon, then a suitable flow rate ratio of organosilicon compound, oxygen and inert gas is about 1:0.6:1.2. Other flow rate ratios may be used, however, if desirable.

In addition to the necessary organosilicon, oxygen and inert gas in the gas stream, minor amounts (not greater than about 1:1 with respect to the organosilicon, more preferably about 0.4 to 0.1:1 with respect to the organosilicon) of one or more additional compounds in gaseous form may be included for particular desired properties. For example, inclusion of a lower hydrocarbon such as propylene improves many frequently desired properties of the deposited films (except for light transmission), and bonding analysis indicates the film to be silicon dioxide in nature. Use of methane or acetylene, however, produces films that are silicone in nature. The inclusion of a minor amount of gaseous nitrogen to the gas stream increases the deposition rate, improves the transmission and reflection optical properties on glass, and varies the index of refraction in response to varied amounts of N2. The addition of nitrous oxide to the gas stream increases the deposition rate and improves the optical properties, but tends to decrease the film hardness. A particularly preferred gas stream composition has 20 to 40 SCCM organosilicon, 20 to 40 SCCM $O_2$, 40 to 60 SCCM He, l to 10 SCCM propylene and 5 to 20 SCCM $N_2$.

In practice of the inventive method, a glow discharge plasma is established in the previously evacuated chamber. This plasma is derived from one or more of the gas stream components, and preferably is derived from the gas stream itself. The desired substrate is positioned in the plasma, preferably adjacent the confined plasma, and the gas stream is controllably flowed into the plasma. The substrate is preferably conveyed into and out of the plasma adjacent the confined plasma for a sufficient number of passes to obtain the desired film thickness.

The inventive method is preferably practiced at relatively high power and quite low pressure. Thus, for example, most of the films have been prepared at about 1,000 watts (40 kHz), although films have been prepared at 375 watts (13.56 MHz), and some at 300 watts, direct current. A pressure less than about 100 microns (0.1 Torr) should be maintained during the deposition, and preferably the chamber is at a pressure between about 8 to 40 microns during the deposition of film.

The substrate is electrically isolated from the system (except for "electrical" contact when in the plasma) and is at a temperature of less than about 80° C during the depositing. That is, the substrate is not deliberately heated.

The flow control is selective for desired film properties, and preferably is by a diagnostics method that includes monitoring a ratio of a hydrogen (alpha) to inert gas emission lines and an electron temperature in the plasma. The general vacuum system in which the inventive method may be practiced and the preferred diagnostics method will now be more fully described.

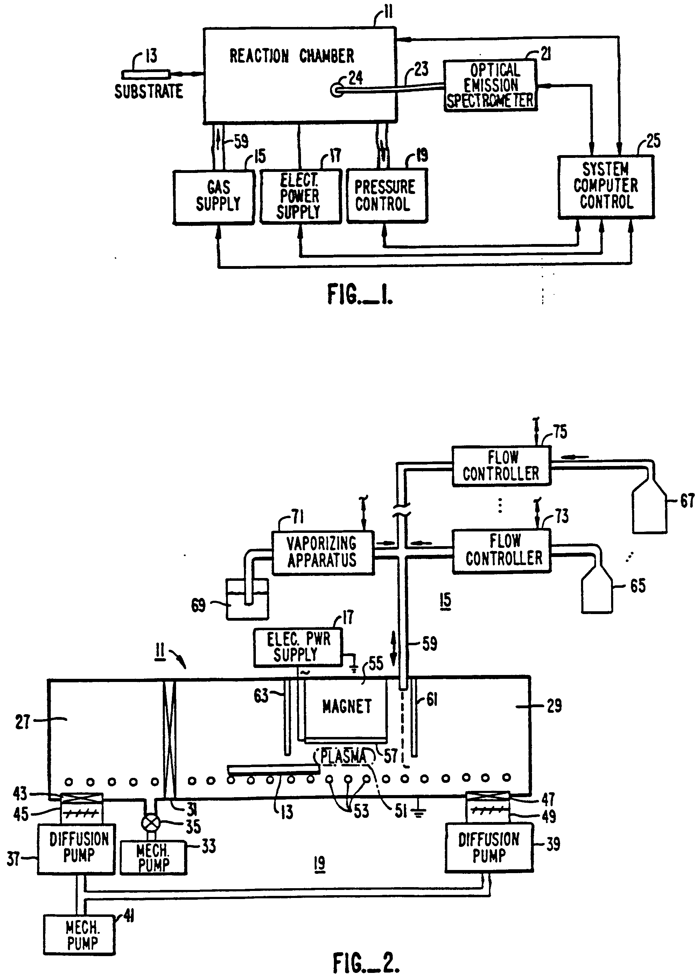

Referring initially to Figure 1, a system is schematically illustrated that includes an enclosed reaction cham-

4

ber 11 in which a plasma is formed and in which a substrate, such as substrate 13, is placed for depositing a thin film of material on it. The substrate 13 can be any vacuum compatible material, such as metal, glass, plastics and other coated substrates. One or more gases are supplied to the reaction chamber by a gas supply system 15. An electric field is created by a power supply 17, and a low pressure is maintained by a pressure control system 19. An optical emission spectrometer 21 is connected through an optical fiber light transmission medium 23 to the reaction chamber in some appropriate manner to couple the visible and near visible (especially the ultraviolet range) emission of the plasma to the spectrometer. A quartz window 24 in a side wall of the reaction chamber can be used to optically couple the plasma emission with the external fiber medium 23. A general system control 25, including a computer control portion, is connected to each of the other components of the system in a manner to receive status information from them and send controlling commands to them.

The reaction chamber 11 can, in the system of Figure 1, be of an appropriate type to perform any of the plasma-enhanced chemical vapor deposition (PECVD) or plasma polymerization processes. A more detailed explanation of certain components of the system of Figure 1 is given with respect to Figure 2, an example of the PECVD or plasma polymerization process being given. The reaction chamber 11 is divided into a load lock compartment 27 and a process compartment 29 by an isolation gate valve 31. The pressure control system 19 includes a mechanical pump 33 connected to the load lock chamber 27 by a valve 35. The pressure control system also includes diffusion pumps 37 and 39, and an associated mechanical pump 41. The diffusion pump 37 is connected to the load lock chamber 27 through an isolation gate valve 43 and an adjustable baffle 45. Similarly, the diffusion pump 39 is connected to the process chamber 29 through an isolation gate valve 47 and an adjustable baffle 49. The baffle 49 is controlled by the system control 25, while a coating process is being carried out, in order to maintain the internal pressure at a desired value.

A substrate to be coated is first loaded into the load lock compartment 27 with the valve 31 closed. The mechanical pump 33 then reduces the pressure most of the way to the high vacuum region. The diffusion pump 37 is then operated to reduce the pressure further, to about $5 \times 10^{-6}$ Torr. The operating pressure is typically in the neighborhood of 30 microns for a PECVD or plasma polymerization process and is achieved by flowing the process gases into the reaction chamber and throttling diffusion pump 39 using baffle 49. During loading and unloading operations, the diffusion pump 39 maintains the deposition chamber 29 at the operating pressure. Once the load lock chamber 27 is reduced to base pressure, the valve 31 is opened and the substrate 13 moved into the deposition chamber 29.

Provision is made for moving the substrate 13 back and forth through a region 51 where a plasma is formed. In the example system being described, this is accomplished by a plurality of rollers 53, preferably made of aluminum with substrate supporting, electrically insulated O-ring spacers. The rollers or similar material are driven by a motor source (not shown) to rotate about their axes at controllable speeds and thus move the substrate 13. During deposition the substrate 13 can be passed back and forth through the plasma 51 a number of times in order that the thin film deposited on the top of the substrate 13 has a desired uniform thickness. Alternatively and more preferably, a roll coating apparatus can be used so a one-pass coating with reproducible thickness is achieved.

A magnetron is positioned within the chamber 29, formed of a magnetic structure 55 and a cathode 57. The power supply 17 has its output connected between the cathode 57 and a metallic body of the reaction chamber 29. The magnetron creates an appropriate combination of magnetic and electrical fields in the region 51 in order to create a plasma there when the proper gases are introduced into the reaction chamber 29. The substrate 13 is maintained electrically isolated and is passed directly through the plasma region 51.

The gaseous components necessary for the plasma to form in the region 51 are introduced into the deposition chamber 29 by a conduit 59. A tube (not shown) having a plurality of gas supply nozzles along its length is positioned across the width of the chamber 29 (in a direction into the paper of Figure 2) at the position where the conduit 59 enters the chamber. That gas flows within the deposition chamber 29 from the supply tube to the diffusion pump 39, as shown in dotted outline in Figure 2. It was found preferable to introduce the gas on the side of the plasma region 51 that is closest to the pump 39. However, more than one diffusion pump 39 can be utilized with gas introduction being substantially equidistant from the pumps. A pair of baffles 61 and 63 on either side of the magnetron can help to confine the gas flow to the plasma region 51.

A particular gas supply system 15 that is connected to the conduit 59 depends, of course, on how many gases are being combined and their nature. In the example of Figure 2, two separate sources 65 and 67 of gases under high pressure are utilized, fewer or additional such gas sources being necessary for other processes. Also, in this particular example, a source 69 of a liquid material to be vaporized is provided. A vaporizing apparatus 71 (that also controls flow) provides the desired flow of vapor into the input conduit 59, in accordance with a control signal from the system control 25. Similarly, the high pressure gases 65 and 67 are delivered through individually controlled flow meters 73 and 75, respectively. An important control of the plasma 51, and thus of the resulting film deposited on the substrate 13, is provided by the ability to adjust the proportions of each gaseous component that is flowing through the inlet tube 59 and into the deposition chamber 29. The flow meters 73 and 75 and vaporizing apparatus 71 each supply the system control 25 with an electrical signal proportional to the flow rate of gas through it, and also responds to a signal from the system control 25 to adjust and control that flow rate.

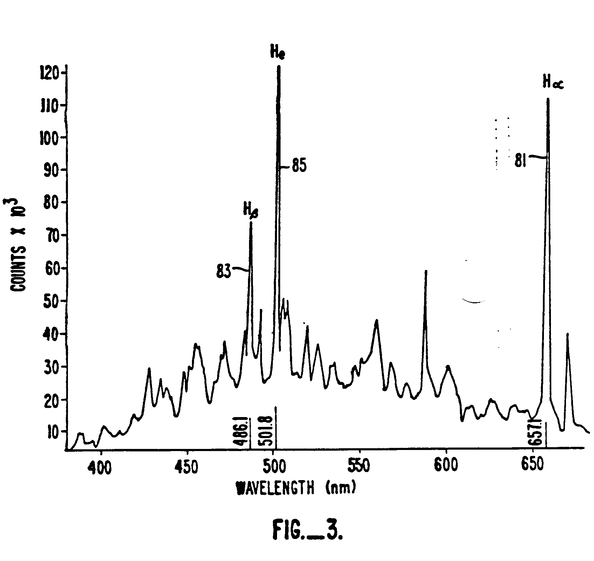

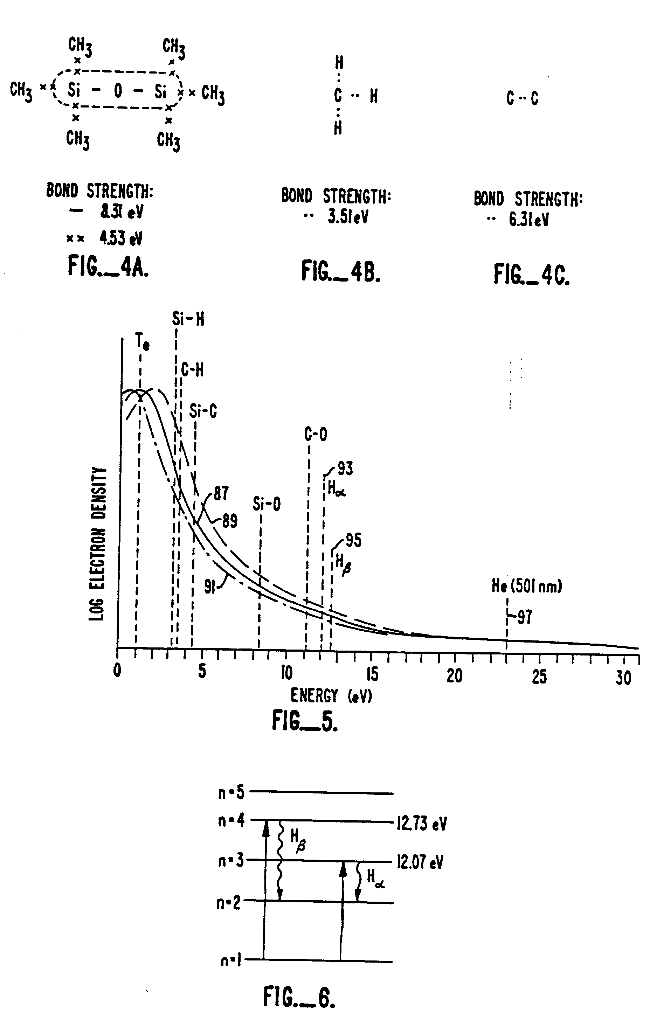

A primary goal of the system and procedures to be described in this section is to adapt the system described with respect to Figures 1 and 2 for use in a continuous, commercially feasible process that repeatably produces thin films having uniform characteristics. A specific example of such a system is described with respect to Figures 3-7 herein. In this illustrative example, the liquid 69 is an organosilicon, and the pressurized gases 65 and 67 are oxygen and helium, respectively. The particular organosilicon chosen for illustration is hexamethyldisiloxane (HMDSO), its structure being illustrated in Figure 4A. The result of this example PECVD process is a thin film that is very hard, scratch resistant, optically clear and adheres well to substrates. The diagnoses and control techniques about to be described with respect to a particular example have a wide and general application to numerous other specific plasma processes and starting gaseous materials in thin film deposition processes.

Figure 3 is an example optical emission spectrum obtained by the spectrometer 21 of Figure 1 from a plasma formed in the process chamber 29 from such a combination of gases. The intensities of three strong emission lines are measured and used to diagnose the characteristic of the plasma and then to make any adjustments to the relative proportion of the gaseous constituents that are required to maintain the plasma in a desired condition. These lines are the hydrogen alpha line 81, at about 657.1 nanometers wavelength, the hydrogen beta line 83, at about 486.1 nanometers wavelength, and a helium emission line 85, at about 501.8 nanometers wavelength. Since these three emission peaks are very strong relative to the intensity of the surrounding portion of the spectra, and are very narrow in bandwidth, the spectrometer 21 need have a resolution capability of only 1 nanometer, which is well within the resolving power of commercially available instruments.

In order to eliminate the effects of unknown variables and undesired optical signal noise, ratios of these intensity levels are utilized to diagnose the plasma and control the process. In this example, the ratio of the intensity of the hydrogen alpha line 81 to the intensity of the helium line 85 is used to control the rate of flow of the silicon source material vapor through the vaporizing apparatus 71. When that ratio exceeds a reference value, the computer control system 25 causes the vaporizing apparatus 71 to decrease the rate of flow of the silicon material vapor, without affecting the flow rates of the other gases. Also, if that ratio falls below the reference value, the vaporizing apparatus 71 is opened to increase the flow of the silicon source material vapor.

A second ratio that is utilized is of the intensities of two emission lines of a single atomic or molecular species in the plasma. In this specific example, the intensities of the hydrogen alpha line 81 and the hydrogen beta line 83 are used. As explained below, this ratio is proportional to the average electron energy (average electron temperature $T_e$) of the plasma. If this ratio, or the $T_e$ calculated from it, exceeds a reference value, the computer control 25 causes the flow meter 73 to increase the flow of oxygen without affecting the rate of flow of the silicon source vapor or helium. If the intensity ratio, or the $T_e$ calculated from it, falls below a reference value, the rate of oxygen flow is caused to decrease. A higher proportion of oxygen is believed to cause the average electron energy to decrease by combination with atomic hydrogen which is a primary source of electrons in this gaseous mixture.

The nature of our example plasma will now be explored, and the relationship of the emission line intensity ratios to it will be explained. Figure 4A illustrates a molecule of the silicon source vapor. It is desired that the portion Si-O-Si be deposited on the substrate. As noted in Figure 4A, the bond energy between the silicon and oxygen atoms is significantly higher than the other bonds in the molecule. That bond strength is 8.31 electron volts. The bond between the silicon atom and the methyl group $CH_3$ is 4.53 electron volts. Figure 4B shows the methyl group with a carbon/hydrogen bond of 3.51 electron volts. Therefore, in a plasma having a distribution of high energy electrons colliding with the silicon source molecules, there is a high probability that a collision of an electron with the molecule will cause a methyl group or hydrogen to be fractured away from the rest of the molecule without affecting the Si-O-Si component. The oxygen introduced into the plasma is believed to combine with the hydrogen and the carbon to form various gas and vapor compounds that are exhausted out of the deposition chamber 29 through the diffusion pump 39. This is another benefit of the oxygen component of the plasma gas. In this example, it is desired to minimize, or completely eliminate, any carbon from the deposited film. An inorganic thin film is the goal.

A theoretical Maxwellian distribution of the energies of a population of electrons in the plasma is given in Figure 5. A solid curve 87 shows one such distribution. The electron population represented by curve 87 has an average energy $T_e$. When the population of electrons have a higher enery, the distribution of energies shifts, such as shown by the dotted curve 89, but retains its basic shape. Similarly, if the overall energy of a population of electrons decreases, the curve shifts to a lower position, such as indicated by the alternate curve 91.

It can be seen from Figure 5 that the proper position for the electron energy distribution curve is where the density of electrons with energy sufficient to break the Si-C bond is much greater than the density of electrons having an energy great enough to undesirably break the Si-O bond. It can be seen from the shape of the curves of Figure 5 that this does indeed occur, keeping in mind that the vertical electron density scale is a logarithmic one. Indeed, it has been found that the distribution represented by the solid line 87 is approximately optimum in the example being described, a $T_e$ of slightly over 1.0 being desired.

It will also be noted from Figure 5 that the three emission lines discussed with respect to Figure 3 are also represented. The hydrogen alpha line 93 is positioned at about 12 electron volts, the hydrogen beta line 95 at about 12.7 electron volts, and the helium line 97 at about 23 electron volts. These energies represent that which the hydrogen or helium atom must absorb from a collision with a free electron in order to emit the monitored wavelength of radiation when the atom relaxes from its excited state.

Figure 6 shows an energy diagram from the hydrogen atom that shows this. A collision with an electron of more than 12. 07 electron volts can cause the atom to become excited with its electron being moved from a ground energy quantum level n=O to a higher energy quantum level n=3. When that excited electron falls to the next lower energy quantum level n=2, the hydrogen alpha wavelength line photon is emitted. Similarly, the hydrogen beta wavelength line photon is emitted when an excited hydrogen atom having collided with an electron of energy greater than 12.73 electron volts relaxes from its excited state, n=4 energy quantum level back to the n=2 energy quantum level. As a result, the intensities of these hydrogen emission lines is related to the density of electrons in the plasma having those energy levels. The ratio of the intensities of these hydrogen emission lines then provides a ratio of those densities. This allows a Maxwellian electron density curve to effectively be fit to those two points, from which the average electron temperature $T_e$ may be determined.

However, the high energy "tail" of the electron energy curve of Figure 5 is desirably separately measured. The hydrogen line intensity ratio is suitable for defining the rest of the curve since the electron densities represented by it are at energy levels in the main part of the energy distribution curve. But the density distribution at higher energy levels can at the same time drop off to very low levels. This is believed due to ineffective energy coupling. Therefore, a separate measurement at a high energy level is also performed. In this example, a helium line of emission is chosen, and that is ratioed with one of the hydrogen lines, preferably the hydrogen alpha line, as a reference. This desired ratio is determined in advance of a deposition process, with the measured ratio being compared to that standard and any adjustments necessary being made in real time.

A quantity of high energy electrons, represented by the "tail" of the curve of Figure 5, is generally desirable for directly impinging upon the substrate since it is known that this improves the hardness of the resulting deposited film through a higher degree of film cross-linking. Stress in the film also decreases, resulting in better adhesion of the film to the substrate. A low ratio in the plasma emission of the hydrogen alpha line intensity to that of helium predicts these beneficial results.

Use of the helium emission line in forming this second ratio is also advantageous since helium is inert. The gas does not combine with other gas components of the plasma. Any inert gas has this advantage, as well as providing an emission line in the "tail" portion of the curve. An inert gas is used in this example primarily for facilitating an initial source of electrons when the plasma is initiated by establishing the electric field. But it has this additional diagnostic use, as well.

Once it is determined from the measured intensities and ratios that the electron energy distribution curve of Figure 5 needs to be altered for a process being performed, it can be done in any of a number of ways. Increasing the excitation frequency of the power supply 17 tends to increase the average energy of the electrons, at least up to a point where the electrons can no longer follow the rapidly changing electric field. The power of the supply 17 may affect the electron energy distribution, depending upon the precise geometry of the deposition chamber, an increase in power increasing the electrical energy. Another variable that may be adjusted is the total gas flow which changes the residence time of molecules within the plasma and increases the chance of collision. The pressure in the chamber 29 also affects molecular energy, within limits. The technique used in this specific example, however, keeps these variables at a constant level and instead changes the ratio of the flow rate of the individual gases into the reaction chamber 29.

The determination of average electron temperature $T_e$ from the ratio of the alpha and beta hydrogen emission line intensities is very significant. Others have suggested that the determination of electron temperature of a plasma from its emission spectra is very difficult, if not impossible. The mathematical relationships between electron temperature and the intensity of a particular emission line have long been known. However, these mathematical relationships also include additional unknowns such as molecular and electron densities in the plasma. With so many unknowns, it is impossible to use these equations directly to accurately determine electron temperature from an intensity of an emission line. However, if the intensities of two such emission lines from a single species within the plasma are ratioed, as is the case with the ratio of the hydrogen alpha and beta lines, these other variables are mathematically canceled out and no longer affect the result. This calculation assumes a "cold" plasma, one where the average ion. energy is very low when compared to the average electron energy.

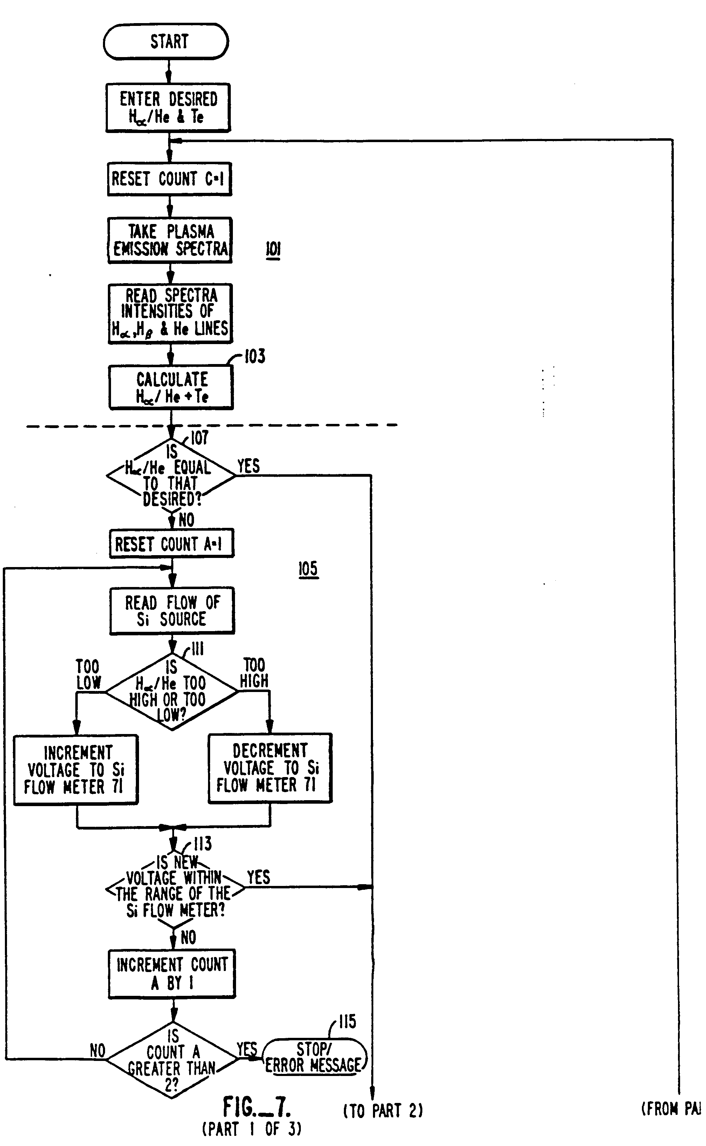

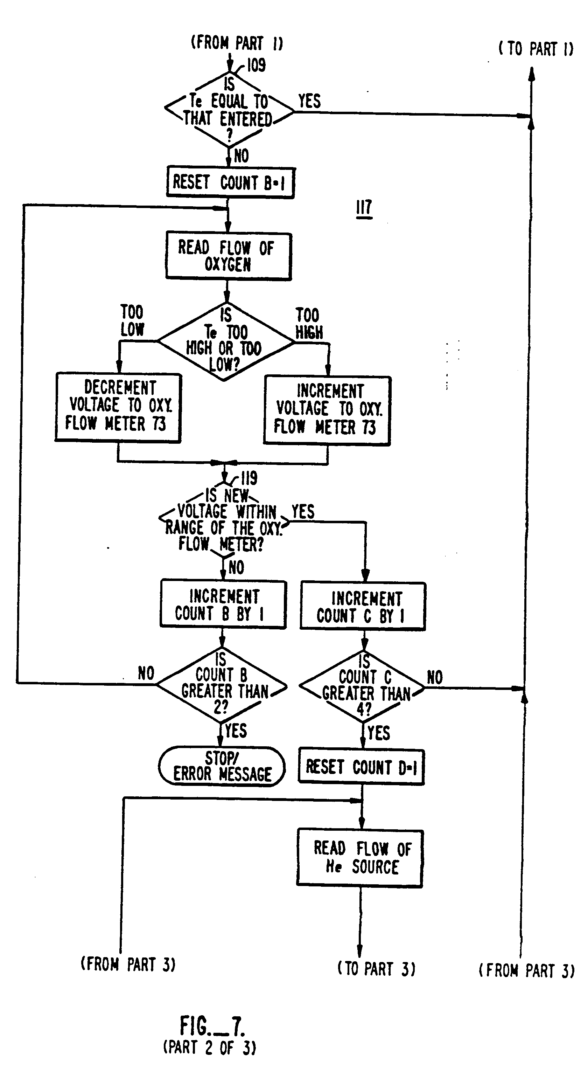

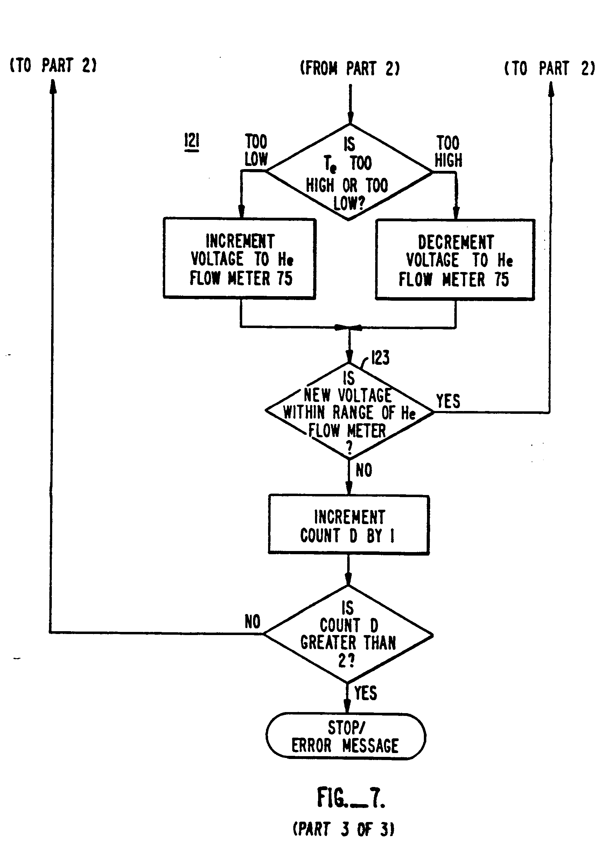

Referring to Figure 7, a flow chart is provided of a controlling computer program that monitors the intensities of the three emission lines and make adjustments in the individual gaseous component flow rates as required to maintain the electron temperature distribution within acceptable limits. The process of Figure 7 can best be described as several functional modules. A first module 101 requires information of both the desired plasma parameters and those that actually exist. It is preferable to enter a desired average electron temperature $T_e$ and then calculate what exists in the plasma, as shown in Figure 7, since this permits the process operator to deal with known quantities. However, since $T_e$ is proportional to the ratio of the hydrogen alpha and hydrogen beta emission lines, that ratio itself could more simply be substituted in the flow diagram of Figure 7 where $T_e$ appears. It would then be that line intensity ratio to which the process is adjusted.

If the preferred $T_e$ is maintained as a parameter in the system, a step 103 calculates that quantity. U.S. Patent No. 4,888,199, issued December 19, 1989, inventors Felts and Lopata included an Appendix that provides source code in Basic language for an Apple Macintosh computer to perform the two calculations indicated in step 103. The computer program is incorporated herein by reference and contains material in which a claim of copyright is made by The BOC Group, Inc., assignee of this application, which has no objection to the duplication of the said Appendix by photocopying and the like but reserves all other aspects of its copyright therein.

Once the actual and desired quantities are in the system, a next module 105 of the processing algorithm looks at the intensity ratio between the hydrogen alpha and the helium emission lines. A first step 107 compares the actual and desired ratios. If they are within range, then the processing component 105 is omitted completely by jumping to a step 109 in the next module 117. However, if the desired and actual ratios are not equal, a step 111 causes the vaporizing apparatus 71 to be adjusted to change the flow of silicon source vapor in a direction to move the compared ratios closer together.

A step 113 of the module 105 checks to make sure that the calculated voltage is within the range of the vaporizing apparatus 71. If it is, the processing proceeds to a step 109. If not, the process loop of module 105 is performed again. If the second calculation also results in a voltage that is not within the range of the vaporizing apparatus 71, then the processing is stopped and an error message displayed for the operator, as indicated at 115.

Once the silicon source vapor flow rate is adjusted, the next module 117 of the processing adjusts the flow of oxygen to the plasma in response to comparing the desired and actual $T_e$. If those quantities are equal within an acceptable tolerance, then the processing loops back to the beginning module 101 and performs the data acquisition and comparison functions once again, and then steps through the remainder of the program. This constant monitoring of the plasma characteristics allows real time control of the plasma for uniform film results and repeatability of film properties from substrate to substrate.

The program module 117 operates quite similarly to that of 105. If the newly calculated voltage for the oxygen supply flow meter is not within the range of that flow meter, as determined by the step 119, the calculation is made once more in case some error occurred. If the voltage is not within the range the second time, the processing is stopped and an error message displayed. Assuming, however, that the new oxygen flow meter valve control voltage is within its range, the processing is looped back to the beginning module 101 and repeated until the processing modules 101, 105 and 117 have been performed for a total of four times. After the fourth time, and if the last calculation loop resulted in a further adjustment to the oxygen flow meter, a next module 121 of processing is undertaken. After four times through the silicon source and oxygen flow rate adjustments, it is concluded that some other adjustment must be made. Of course, the precise number of processing cycles that are allowed before going to the next calculation module 121 can vary.

The module 121 also looks at $T_e$, but in this case adjusts the helium gas flow to the plasma chamber. An increase of the inert gas supply provides more electrons, and a decrease in the gas fewer electrons. The same check on the calculated voltage for the helium flow meter is made in the module 121 as in the modules 105 and 117, in step 123. Once a proper adjustment to the helium flow is made, the processing again loops back to the beginning module 101 to start the cycle over again.

Of course, there are many variations in the details of the process being described that can be changed without sacrificing the advantages provided by the basic emission line monitoring techniques that are so implemented. The same techniques are used with other gases.

Plasma input variables of power of the supply 17 and pressure within the chamber 29 are not included in the algorithm of Figure 7 as quantities that are adjusted automatically. It has been found satisfactory to maintain those quantities fixed for at least a large processing batch. This is preferably accomplished by setting the control system 25 to the desired power and pressure. The control 25 is provided with standard capability of monitoring those quantities and adjusting them, if necessary to maintain the constant levels that have been set.

The magnetron used in the plasma chamber 29 can be of a usual planar magnetron form, a representation of which is given in Figure 8A. A cross-sectional view of the magnet structure 55 is provided at a vertical plane.

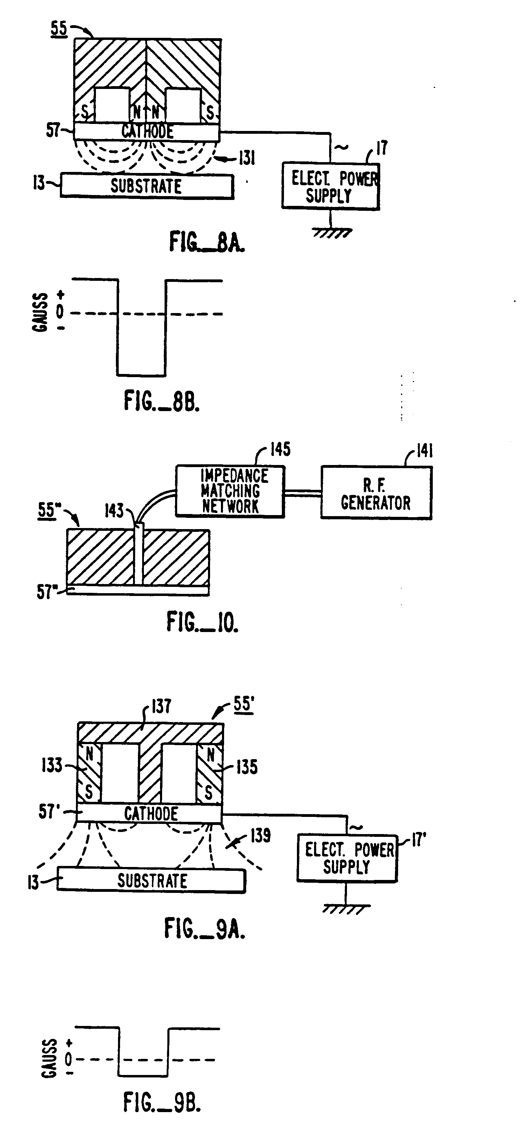

In plan view, the structure of Figure 8 is elongated in a direction normal to the plane of the paper.

The structure of Figure 8A is termed a balanced magnetron. Its magnetic lines of force 131 all travel between one of the outer south magnetic poles and a central north pole. As is well known, electrons and ions travel in a spiral around a magnetic force line and along it, under influence of a combination of the magnetic field forces and the electric field forces formed by the cathode and the process chamber metal case. The cathode 57 is generally made of titanium or quartz, but sputtering is prevented from happening because of the higher pressure (that is, greater than the 1 to 5 microns of sputtering) used in the deposition system of Figure 2.

An unbalanced magnetron that alternatively can be utilized in the system of Figure 2 is shown in Figure 9A. Outside magnets 133 and 135 are arranged with a soft iron core 137 middle. Only the south magnetic poles are positioned against a cathode 57', the north pole faces being oriented away from the cathode. The result is that a substantial proportion of the magnetic field lines follow a much longer path in extending between the magnetic south and north pole regions. Only a small proportion of the force lines extend directly between the outer south pole faces and the central iron core piece. The result is a pattern of magnetic field lines, such as lines 139 of Figure 9A, which are directed towards the substrate 13, most of them substantially perpendicular to its surface. The result is a beneficial bombardment by ions and electrons in the plasma against the surface of the substrate 13. This is known to improve some properties of the resulting deposited film, such as its hardness. Also, the deposition rate has been found to be much better with an unbalanced magnetron structure of Figure 9A rather than the balanced magnetron structure of Figure 8A.

The balanced and unbalanced magnetrons have their relative magnetic field strength distribution across the cathode indicated by diagrams of Figures 8B and 9B, respectively. As can be seen in Figure 8B, the magnetic field strength in the center is twice the field strength of the outer poles. In the unbalanced magnetron case of Figure 9B, however, the center field strength is very weak compared to the field strength of each of the outer magnetic poles. This difference in field strength distribution across the cathode results in the different distribution of the magnetic flux lines 139.

The magnetron structures of Figures 8A and 9A are suitable for low frequency operation of the power supply 17. An example frequency is 40 kHz. However, there can be some advantages from operating at a much higher frequency, such as in the radio frequency range of several megahertz. Such a high frequency system is schematically illustrated in Figure 10. A magnetron magnetic assembly 55" may be either of the balanced or unbalanced types described previously, the unbalanced type being preferred. The cathode 57" is in this case made of a non-conductive quartz material. A radio frequency generator 141 has its output coupled to the cathode 57" by a rod 143. An impedance matching network 145 is connected between the RF generator and the coupling rod 143 in order to minimize any reflections from impedance discontinuities at the cathode 57".

The preferred vaporizing apparatus for practicing the invention is described by U.S. Patent 4,847,469, issued July 11, 1989, inventors Hofmann et al., which description is incorporated herein by reference.

All depositions exemplified were conducted by the general procedure now described and with an Airco Solar Products ILS-1600 research coater with roll-to-roll apparatus and two diffusion pumps. The chamber including load lock was evacuated to a base pressure of not greater than about $3 \times 10^{-5}$ Torr with the roll to be coated located in the machine. Meanwhile, the vaporizer was heated to a constant temperature of 100° C, had vaporized organosilicon therein, but was isolated from the chamber until the gas inlet was opened. The vaporizing apparatus was set for the desired flow reading of organosilicon. The desired gas flows of the additional components were set, and the pressure in the chamber was adjusted to the desired value by adjusting a baffle over the diffusion pump. After the pressure in the chamber stabilized, the power supply was turned on and adjusted to the desired value. Thus, the glow discharge plasma is established in the chamber. The pressure was again stabilized and adjusted if necessary. The desired process conditions were selected (power, current and voltage of the power supply, the pressure of the chamber, the gas flows, and the vaporizer pressure). An emission spectrum from the control program was used to find the appropriate hydrogen (alpha) to inert gas ratio. The helium and oxygen flows into the chamber were adjusted until the desired hydrogen (alpha) to inert gas ratio was obtained. The substrate was then conveyed through the plasma region by means of the roll coating apparatus for the desired coating thickness while continuing to monitor the process conditions and making appropriate adjustments according to the diagnostic method. Once the desired film thickness was obtained, the system was shut down and the coated substrate removed.

The following abbreviations will be used:

PET     - polyethyleneterephthalate
TMDSO   - 1,1,3,3-tetramethyldisiloxane
SCCM    - Standard cubic centimeters per minute
ipm      - Inches per minute
Hα      - Hydrogen alpha emission line at 657 nm.

## Example I

An embodiment of the invention was prepared on a PET substrate having a thickness of 0.5 mils. The organosilicon used was TMDSO. The process conditions selected were:

Power 460 Watts
Current 0.97
Voltage 467
Chamber Pressure 37 microns
Gas Stream Composition TMDSO (15 SCCM); $O_2$ (45 SCCM); He (90 SCCM)
Vaporizer Pressure 200 Torr
Hydrogen (alpha) to inert gas ratio 0.58
Line Speed 18 ipm

The inventive film on this thin, flexible plastic substrate had a coating thickness of less than or about 200 Å and was measured for gas transmission rates of slightly less than about 0.04 cc/100in$^2$/day of oxygen and about 0.04 g/100in$^2$/day of water vapor. The silicon oxide film had a O:Si concentration ratio of about 2:1. The film thickness and composition were determined by FTIR and/or electron spectroscopy for chemical analysis (ESCA).

## Example II

Gas transmission properties for the inventive films on flexible substrates are a function of film thickness, but thicker films do not necessarily provide better gas transmission properties on the thin, flexible substrates. We have discovered there are optimal ranges of thicknesses, depending upon the substrate, for providing maximal barrier properties. This point is illustrated by having coated a 0.5 mils thick PET substrate with varying thicknesses in accordance with the invention and then measuring the oxygen transmission properties of each different thickness. The organosilicon used was TMDSO. The films were prepared in a manner analogous to Example I, but the duration of the deposition was controlled so as to result in the different thicknesses. Table I sets out the different thicknesses and the oxygen transmission for each.

### Table I

| Coating Thickness (Å) | Oxygen transmission (cc/100in$^2$/day) |
|---|---|
| 1969 | 1.24 |
| 1400 | 0.19 |
| 1000 | 0.12 |
| 400 | 0.06 |
| 133 | 0.04 |
| 33 | 1.96 |
| 16 | 4.14 |
| 0 | 7.00 |

As can be seen by the data of Table I, the thin PET film with no coating had an oxygen transmission of 7 cc/100in$^2$/day while a coating in accordance with the invention (but having a thickness of only 16 Å) reduced this oxygen transmission by about 40%. However, of particular interest is the fact that the best barriers were provided at coating thicknesses of 133 Å and (slightly less better) 400 Å, while even thicker coatings then began to provide less of a barrier to oxygen transmissions than the 133-400 Å range coatings.

Accordingly, this data shows that coatings of the invention, when applied to a flexible material, provide thin film vapor barriers with excellent gas barrier performance at significantly reduced thicknesses than found with the typical inorganic based prior art coating. Because these gas barriers can be achieved at reduced thicknesses, production throughputs can be higher and associated costs lower in practicing the invention.

While the invention has been described in connection with specific embodiments thereof, it will be understood that it is capable of further modifications, and this application is intended to cover any variations, uses or adaptations of the invention following, in general, the principles of the invention and including such departures from the disclosure as come within the known or customary practice in the art to which the invention pertains and as may be applied to the essential features hereinbefore set forth, and as fall within the scope of the invention and the limits of the appended claims.

## Claims

1. A method of depositing a silicon oxide based film with vapour barrier properties comprising:

   providing a gas stream including a volatilized organosilicon compound, oxygen, and an inert gas;

   establishing a glow discharge plasma derived from the gas stream in a previously evacuated chamber, the chamber including a substrate removably positionable in the plasma; and

   controllably flowing the gas stream into the plasma to deposit a layer of a silicon oxide onto the substrate when positioned in the plasma having a predetermined thickness of less than about 1000 Å, the deposited silicon oxide being a reaction product of the gas stream, the chamber being maintained at a pressure of less than about 100 microns during the deposition.

2. A method according to Claim 1 in which the inert gas of the gas stream includes helium or argon.

3. A method according to Claim 1 or Claim 2 in which the organosilicon compound is 1,1,3,3-tetramethyldisiloxane, hexamethyldisiloxane, vinyltrimethylsilane, methyltrimethoxysilane, vinyltrimethoxysilane, or hexamethyldisilazane.

4. A method according to any preceding claim in which the deposited silicon oxide is substantially inorganic.

5. A method according to any preceding claim in which the predetermined thickness is less than about 600 Å.

6. A method according to any preceding claim in which the predetermined thickness is selected to provide the silicon oxide layer with a oxygen transmission of less than about 0.1 cc/100in$^2$/day.

7. A method according to any preceding claim in which the predetermined thickness of the silicon oxide layer is between about 100 Å to about 400 Å.

8. A method according to any preceding claim in which the substrate is flexible.

9. A method according to Claim 8 in which the substrate has a thickness less than about 10 mils, and the layer forms a barrier to oxygen transmission therethrough with a oxygen transmission of less than about 0.04 cc/100in$^2$/day.

10. An article comprising:

    a flexible polymer substrate defining a surface and a thin film carried by the surface, the polymer surface and thin film together having a permeability to oxygen gas therethrough that is less than about 0.1 cc/100in$^2$/day, the thin film having a thickness less than about 1000 Å.

11. An article according to Claim 10 in which the thin film is a substantially inorganic silicon oxide.

12. An article according to Claim 10 or Claim 11 in which the thin film thickness is less than about 600 Å.

13. An article according to any one of Claims 10 to 12 in which the thin film thickness is between about 100 Å to about 400 Å and the permeability is less than about 0.04 cc/100in$^2$/day.

14. An article according to any one of Claims 10 to 13 in which the substrate has a thickness of about 1 mil or less.

15. An article according to any one of Claims 10 to 14 in which the substrate includes polyethyleneterephthalate or polycarbonate.

FIG.—1.

FIG.—2.

FIG._3.

CH₃          CH₃
  ×            ×
CH₃ × ⌈ Si — O — Si ⌉ × CH₃
  ×            ×
CH₃          CH₃

BOND STRENGTH:
 —    8.31 eV
 × ×  4.53 eV

FIG._4A.

          H
          ⋮
      H ⋮ C ∙∙ H
          ⋮
          H

BOND STRENGTH:
 ∙∙  3.51 eV

FIG._4B.

    C ∙∙ C

BOND STRENGTH:
 ∙∙  6.31 eV

FIG._4C.

FIG._5.

FIG._6.

START

ENTER DESIRED
$H_\alpha$/He & Te

RESET COUNT C·1

TAKE PLASMA
EMISSION SPECTRA          101

READ SPECTRA
INTENSITIES OF
$H_\alpha$,$H_\beta$ & He LINES

CALCULATE          103
$H_\alpha$/ He + Te

107
IS
$H_\alpha$/He EQUAL
TO THAT
DESIRED?       YES

NO

RESET COUNT A·1          105

READ FLOW OF
Si SOURCE

111
TOO              IS              TOO
LOW          $H_\alpha$/He TOO       HIGH
HIGH OR TOO
LOW?

INCREMENT              DECREMENT
VOLTAGE TO Si          VOLTAGE TO Si
FLOW METER 71          FLOW METER 71

113
IS NEW
VOLTAGE WITHIN
THE RANGE OF THE       YES
Si FLOW METER?

NO

INCREMENT COUNT
A BY 1

115
IS
NO       COUNT A       YES      STOP/
GREATER THAN           ERROR MESSAGE
2?

FIG._7.          (TO PART 2)          (FROM PA
(PART 1 OF 3)

15

(FROM PART 1)                                                    ( TO PART 1)

109

IS Te EQUAL TO THAT ENTERED ?  →  YES

NO

RESET COUNT B=1

117

READ FLOW OF OXYGEN

TOO LOW  ←  IS Te TOO HIGH OR TOO LOW?  →  TOO HIGH

DECREMENT VOLTAGE TO OXY. FLOW METER 73

INCREMENT VOLTAGE TO OXY. FLOW METER 73

119

IS NEW VOLTAGE WITHIN RANGE OF THE OXY. FLOW METER?  →  YES

NO

INCREMENT COUNT B BY 1

INCREMENT COUNT C BY 1

NO  ←  IS COUNT B GREATER THAN 2?

IS COUNT C GREATER THAN 4?  →  NO

YES

YES

STOP/ ERROR MESSAGE

RESET COUNT D=1

READ FLOW OF He SOURCE

(FROM PART 3)                    ( TO PART 3)         ( FROM PART 3)

FIG._7.
(PART 2 OF 3)

16

FIG.__7.

(PART 3 OF 3)

FIG._8A.

FIG._8B.

FIG._10.

FIG._9A.

FIG._9B.

**European Patent Office**

**EUROPEAN SEARCH REPORT**

Application Number

EP    91 30 7124

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X,D Y,D | EP-A-0 299 754 (THE BOC GROUP INC.) <br> * page 3, line 4 - line 6; claims 1,9-16 * <br> --- | 1-5,7,8 <br> 6,9-15 | C08J7/06 <br> B65D65/40 <br> C23C16/40 |
| Y | EP-A-0 311 432 (MITSUBISHI MONSANTO CHEMICAL CO. ) <br> *EXAMPLES* <br> ----- | 6,9-15 | |
| | | | **TECHNICAL FIELDS SEARCHED (Int. Cl.5 )** <br><br> C23C <br> C08J <br> B65D |

The present search report has been drawn up for all claims

| Place of search | Date of completion of the search | Examiner |
|---|---|---|
| THE HAGUE | 08 NOVEMBER 1991 | PATTERSON A.M. |